# EUROPEAN PATENT APPLICATION

(11) **EP 1 624 495 A1**
(43) Date of publication of application: **08.02.2006**
(21) Application number: 04016553.2
(22) Date of filing: 14.07.2004
(51) Int. Cl.: H01L 33/00

(54) **High light efficiency GaN-based LED and its manufacturing method**

(71) Applicant: SuperNova Optoelectronics Corporation, Pingjhen City Taoyuan County 324 (TW)
(72) Inventor: Lai, Mu-Jen, Pingjhen City Taoyuan County 324 (TW); Hon, Schang-Jing, Pingjhen City Taoyuan County 324 (TW)
(74) Representative: Winkler, Andreas Fritz Ernst

(57) **Abstract**

A high light efficiency of GaN-series of light emitting diode and its manufacturing method thereof disclose a process and structure of a p-type semiconductor layer of surface texture structure generation. The optical waveguide effect can be interrupted and the possibility of hexagonal shaped pits defect generated can be reduced through said texture structure. The method explores that controlling the tension and compression of strain while a p-type cladding layer and a p-type transition layer are generated, and then a p-type ohmic contact is formed on said p-type transition layer. Through the control and its structure of said epitaxial growth process, the surface of said p-type semiconductor layer is with texture structure to increase external quantum efficiency and its operation life.

## Description

### Background of the Invention

### 1. Field of the Invention

The present invention relates to a high light efficiency of GaN-series of light emitting diode and its manufacturing method thereof, especially for a GaN-series light emitting diode and its manufacturing method thereof, which using controlling the strain of epitaxy layer during the process of epitaxial growth to form a p-type semiconductor layer with surface textured structure to interrupt the optical waveguide effect.

### 2.Description of the Related Art

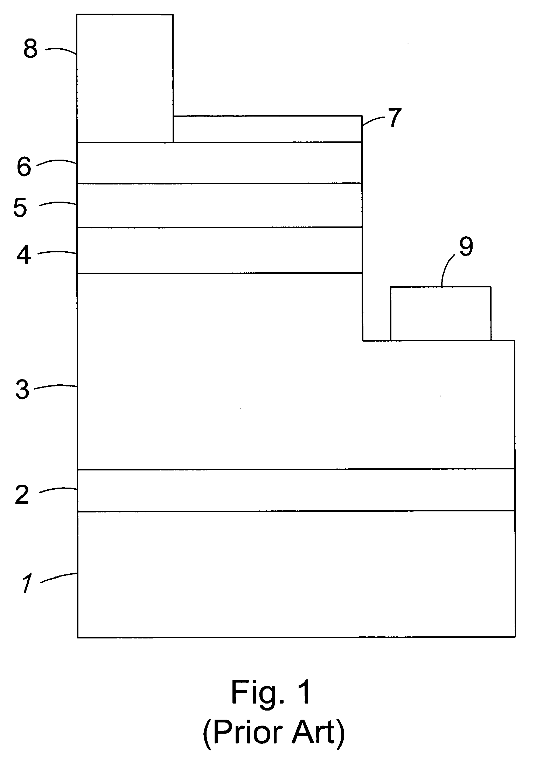

Using sapphire substrate grown GaN-series light emitting diode , according to prior art, shows as Fig.1 which is so-called conventional structure, wherein consisting of a GaN buffer layer 2, a n-type GaN ohmic contact 3, a InGaN light emitting layer 4, a p-type AIGaN cladding layer 5 and a p-type GaN ohmic contact layer 6 of epitaxially grown sequentially on the sapphire substrate 1, wherein making a semi-transparent metal conductive layer 7 on the p-type GaN ohmic contact layer 6, and making a p-side electrode 8 on the semi-transparent metal conductive layer 7 and making a n-side electrode 9 on the GaN ohmic contact 3. Because of the refraction index distribution of said GaN epitaxial structure (n=2.4), sapphire substrate (n=1.77) and resin capping materials for packaging (n=1.5), only 25% of light emitting from the light emitting layer can be output directly and not be reflected by the interface, and the rest of 75% of light are limited by the optical waveguide structure composed by the sapphire substrate and resin capping materials for packaging and increase the possibilities of light reabsorption through several times interface reflection, and not be able to further be effective extract output and utilization. Hence, the extracting efficinecy of said light emitting diode is limited by the absorption of the semi-transparent metal conductive layer and reabsorption of internal epitaxial structure.

In order to improve the extracting efficiency of above mentioned light emitting diode, refers to the US patent 6,091, 085 , disclosed that a method of interrupting the optical waveguide effect, wherein said a method is firstly generating rough texturing on the surface of sapphire substrate, and then grown multi-layer epitaxial structure of GaN-series of light emitting diode. And the other method is to directly grow the epitaxial structure of GaN-series of light emitting diode on the sapphire substrate, and then directly produce tunnel channels on the surface of epitaxial structure. The said tunnel channels extends to the direction of sapphire substrate and is embedded the materials whose refraction index is smaller than the one (n=2.4) of multi-layer GaN epitaxial structure.

However, because the method one requires utilizing a method of mechanical polishing or chemical etching to produce said rough texturing so it easily causes the non-uniformity of surface roughness on the sapphire substrate and then influence the conditions of next epitaxial structure and also not easily to control the manufacturing yield. Besides, the method two increases the complexity of fabrication and manufacturing cost because of making tunnel channels and embedded materials.

Besides, the US patent 6,495,862 explores that a surface convexification of GaN-series of light emitting diode which can reduce the light emitted from the light emitting layer is reflected by semi-transparent metal conductive layer and the interface of resin capping for packaging and then increases external quantum efficiency. But the complexity of fabrication and manufacturing cost are increased in order to make the said surface with cylindrical or semi-circle convex texture.

Moreover, the US patent 6,531,710 explores that a method which interrupts the optical waveguide effect and reduces flexural distortion generated from stress caused by epitaxy process which illustrates utilizing the conditions of epitaxial growth grows the internal layer of AIN having reticulate linear structure which locates between the light emitting layer and sapphire substrate to interrupt the optical waveguide effect and increase external quantum efficiency. Moreover, the said structure can be formed a metal reflection layer on the said AIN internal layer to reflect the light from the light emitting layer directing to the sapphire substrate to increase external quantum efficiency. This patent discloses that injecting ammonia gas (NH3) and trimethyalumium (TMA) into reaction chamber and controlling the flow of ammonia gas, while the said internal layer of AIN growth by utilizing the metal organic chemical vapor deposition (MOCVD), achieves to control the reticulate linear shape and then grow other multi-layer epitaxial structure. However, this method easily tends to cause in the hexagonal shaped pits, according to the thesis (APL 71, (9), sep.1(1997), P.1204). If the said pits very easily extends to the surface of p-type ohmic contact layer from the internal layer of AIN which will causes the metal atoms diffuse into the light emitting layer to disrupt the characteristics of light emitting diode device and shorten the operation life of device when the consecutive semi-transparent conductive metal layer or metal electrode being produced.

According to the thesis of J.L.Rouviere et al (Journal of Nitride-Semiconductor-Research, Vol.1, (1996) Art.33) illustrates that the shape of surface presents three types of hexagonal pyramid shaped roughness, flat, and granular roughness in accordance with the different conditions of epitaxial growth, while the thin film of GaN grown on the sapphire substrate by using MOCVD skill. The experiment proves that the presented shaped of surface is determined by the polarization direction and migration rate of surface atoms. When the mechanism of surface growth is mainly controlled by the N-polarity, the surface shape is roughness; when the mechanism of surface growth is mainly controlled by the Ga-polarity, the surface shape is flat; and when the surface of GaN thin film is flat, the possibility of hexagonal shaped pits generated being reduced and even disappeared.

Therefore, providing a novel high light efficiency of GaN-series of light emitting diode and its manufacturing method thereof can eliminate the drawbacks from the prior arts, such as mechanical polishing or chemical etching to interrupt the optical waveguide effect. Based on the inventor engaging on the research and develop and sales experiences for the related products for many years, the inventor finally proposes a method to improve the aforementioned problems for improving a high light efficiency of GaN-series of light emitting diode and its manufacturing method thereof according to his professional background.

### Summary of the Invention

The primary purpose of the present invention is to provide a high light efficiency of GaN-series of light emitting diode and its manufacturing method, wherein controlling the strain of the followmentioned two layers while epitaxially growing a p-type cladding layer and a p-type transition layer is formed on the said cladding layer, then forms a p-type ohmic contact layer on the said p-type transition layer , which makes the surface of p-type semiconductor layer having textured structure. The optical waveguide effect can be interrupted and increase external quantum efficiency through the said textured structure.

The secondary purpose of the present invention is to provide a high light efficiency of GaN-series of light emitting diode and its manufacturing method, wherein the generation method of the said p-type semiconductor layer enables to reduce the generation possibility of hexagonal shaped pits to increase its operation life.

In order to perform the aforementioned purposes, efficiency and characteristics of each, the present invention explores that a method and structure of a p-type semiconductor layer having surface textured structure, and the optical waveguide effect can be interrupted and reduce the hexagonal shaped pits generation through the generation of textured structure. The present invention discloses a method that epitaxially growing a p-type cladding layer and further growing a p-type transition layer on the said the cladding layer, controlling the strain during growing the two of aforementioned layer , then forms a p-type ohmic contact layer on the said p-type transition layer to make the surface of p-type semiconductor layer having textured structure and get the results of increasing external quantum efficiency and improve the operation life.

### Brief Description of The drawings

Fig. 1 is a sectional view showing a light emitting diode of prior art.
Fig. 2 is a manufacturing flow chart of light emitting diode showing a preferred embodiment in accordance with the present invention.
Fig. 3 is a conceptional perspective view illustrating a preferred embodiment of light emitting diode according to the present invention.
Fig. 4A-4E are surface photographs of showing p-type semiconductor layer of a textured structure according to the preferred embodiment of the present invention.

### Detailed Description of the Preferred Embodiments

In order to clearly express and explore the feature characteristics and efficiency of the present invention for the committee of patent, the preferred embodiment and detailed description is as below.

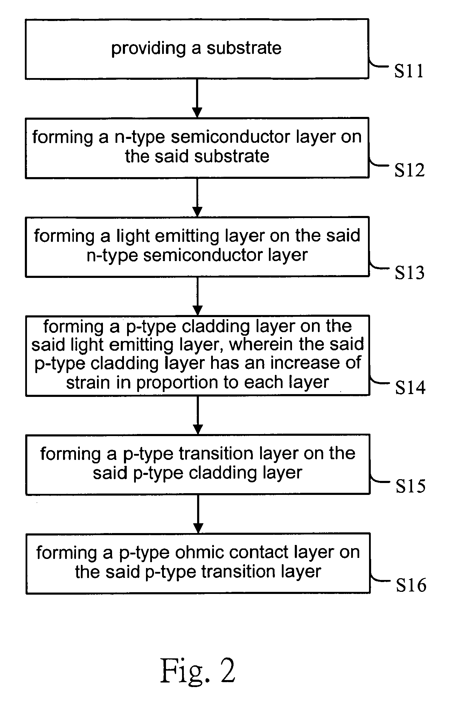

The present invention is a method and a structure of interrupting optical waveguide effect and aims to solve the prior arts which all apply for post process such as mechanical polishing, or chemical etching or the disclosed method by the MOCVD epitaxy skill to generate the textured surface that easily makes hexagonal shaped pits and then causes in the operation life short and the production yield is not controllable, Hence, the process and structure of the present invention are novel arts which do not require the post machining process and not cause in hexagonal shaped pits
Firstly, refer to Fig. 2 which illustrates the manufacturing flow chart of one of the preferred embodiment of light emitting diode of the present invention, which comprises the steps of
Step 11: providing a substrate;
Step 12: forming a n-type semiconductor layer on the said substrate;
Step 13: froming a light emitting layer on the said n-type semiconductor layer;
Step 14: forming a p-type cladding layer on the said light emitting layer, wherein the said p-type cladding layer has an increase of strain in proportion to each layer;
Step 15: forming a p-type transition layer on the said p-type cladding layer; and
Step 16: forming a p-type ohmic contact layer on the said p-type transition layer.

From step 14 to step 16, the increase strain of p-type cladding layer and a method of forming a p-type semiconductor layer with textured surface consists of the methods of:
1. P-type cladding layer contains a magnesium (Mg) dopant with high concentration to increase the strain of epitaxial layers, then interrupt the epitaxial growth and control the interruption time to alter the strain in proportion to epitaxial layers, wherein the interruption time is between one second to two minutes, next growing a p-type transition layer containing a magnesium (Mg) dopant with lower concentration , and lastly growing a p-type ohmic contact layer containing a magnesium(Mg) dopant with proper concentration .
2. P-type cladding layer contains a magnesium (Mg)dopant with high concentration to increase the strain of epitaxial layers, then interrupt the epitaxial growth and utilize the change of temperature to alter the strain in proportion to epitaxial layers, wherein the said temperature is in a range of from 5°C to 300°C, next growing a p-type transition layer containing a magnesium(Mg) dopant with lower concentration , and lastly growing a p-type ohmic contact layer containing a magnesium(Mg) dopant with proper concentration.
3. P-type cladding layer contains a magnesium (Mg) dopant with high concentration to increase the strain of epitaxial layers, then interrupt the epitaxial growth and form several monolayers of gallium, indium or aluminum on the surface of p-type cladding layer to alter the strain in proportion to epitaxial layers, wherein the monlayer is from one to five, next growing a p-type transition layer containing a magnesium(Mg) dopant with lower concentration, and lastly growing a p-type ohmic contact layer containing a magnesium(Mg) dopant with proper concentration .
4. Increasing aluminum composition of p-type cladding layer to raise the strain of epitaxial layers, then interrupt the epitaxial growth and control the interruption time to alter the strain in proportion to epitaxial layers, wherein the interruption time is between one second to two minutes, next growing a p-type transition layer containing a magnesium(Mg) dopant with lower concentration , and lastly growing a p-type ohmic contact layer containing a magnesium(Mg) dopant with proper concentration .
5. Increasing aluminum composition of p-type cladding layer to raise the strain of epitaxial layers, then interrupt the epitaxial growth and utilize the change of temperature to alter the strain in proportion to epitaxial layers, wherein the said temperature is in a range of from 5°C to 300°C, next growing a p-type transition layer containing a magnesium(Mg) dopant with lower concentration, and lastly growing a p-type ohmic contact layer containing a magnesium(Mg) dopant with proper concentration .
6. Increasing aluminum composition of p-type cladding layer to raises the strain of epitaxial, then interrupt the epitaxial growth and form several monolayers of gallium, indium or aluminum on the surface of p-type cladding layer to alter the strain in proportion to epitaxial layers, wherein the monlayer is from one to five, next growing a p-type transition layer containing a magnesium(Mg) dopant with lower concentration , and lastly growing a p-type ohmic contact layer containing a magnesium(Mg) dopant with proper concentration .

And the method of forming the said p-type transition layer describes as follows:
1. To control the composition of aluminum among the epitaxy or a dopant of magnesium reduce the strain between epitaxial layers and p-type cladding layer.
2. To reduce the strain between epitaxial layers and p-type cladding layer,next to interrupt epitaxial growth and to control the interruption time to alter the strain in proportion to epitaxial layers, wherein the said interruption time is in a range of from one second to two minutes.
3. To reduce the strain between epitaxial layers and p-type cladding layer, next to interrupt epitaxial growth and to utilize the change of temperature to alter the strain in proportion to epitaxial layers, wherein the said temperature is in a range of from 5°C to 300°C.
4. To reduce the strain between epitaxial layers and p-type cladding layer, next to interrupt epitaxial growth and to form several monolayers of gallium, indium or aluminum on the surface of p-type cladding layer to alter the strain in proportion to epitaxial, wherein the monolayer is from one to five.

The method of forming said p-type ohmic contact layer is to utilize epitaxial growth to increase bis(cyclopentadienyl) magnesium (Cp₂Mg) flow or reduce temperature to increase magnesium doping concentration.

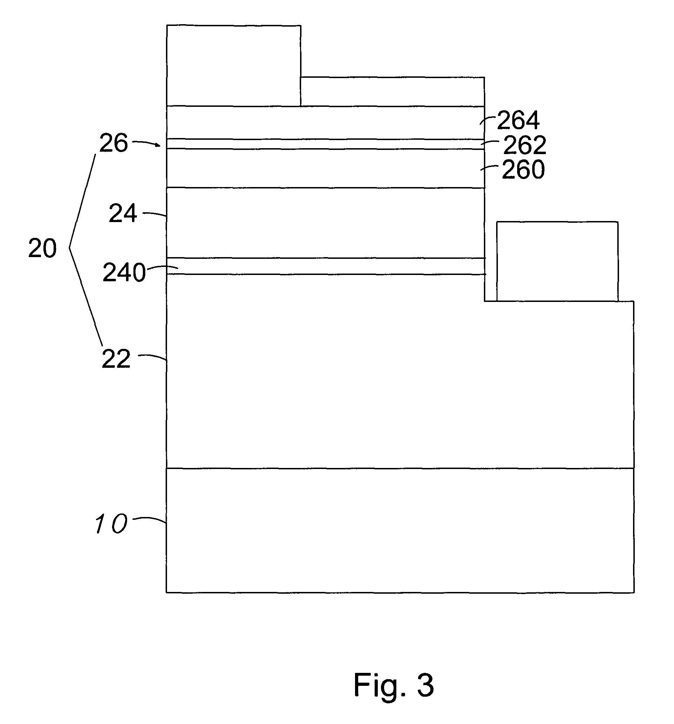

Moreover, refer to Fig.3, which is a schematic diagram of one of a preferred embodiment of light emitting diode of the present invention. Fig.3 illustrates the main structure of a high light efficiency of GaN-series of light emitting diode comprising of: a substrate 10, the said substrate locates on the bottom of the said light emitting diode device; a semiconductor layer 20, the said semiconductor layer having a n-type semiconductor layer 22, a light emitting layer 24 and a p-type semiconductor layer 26 formed on the top of the said substrate 10 , wherein the said light emitting layer 24 locates between the said n-type semiconductor layer 22 and the said p-type semiconductor layer 26; the said p-type semiconductor layer 26 further containing a p-type cladding layer 260, a p-type transition layer 262 and p-type ohmic contact layer, sequently growing on the said light emitting layer 24 and the said p-type cladding layer 260 is a cladding layer of increasing the strain; moreover, can further contain a reflection layer 240 whose structure could be a Distributed Bragg Reflector stacked by semiconductor layer under the said light emitting layer 24.

The said substrate 10 is selected from one of sapphire, silicon carbide, zinc oxide, zirconium diboride, gallium arsenide or silicon; and the said n-type semiconductor layer 22 can be presented as N- B ₓ Al _{y} In _{z} Ga _{1-x-y-z} N p Asq (0≦x≦1, 0≦y≦1, 0≦z≦1, 0≦p≦1, 0≦q≦1, and x+y+z=1, p+q=1), or presented as N- B ₓ Al _{y} In _{z} Ga _{1-x-y-z} N ₚ P_{q} (0≦x≦1, 0≦y≦1, 0≦z≦1, 0≦p≦1, 0≦q≦1, and x+y+z=1, p+q=1); the said p-type semiconductor layer 26 can be presented as P- B ₓ Al _{y} In _{z} Ga _{1-x-y-z} N ₚ As_{q} (0≦x≦1, 0≦y≦1, 0≦z≦1, 0≦p≦1, 0≦q≦1, and x+y+z=1, p+q=1), or presented as P- B ₓ Al _{y} In _{z} Ga _{1-x-y-z} N p Pq (0≦x≦1, 0≦y≦1, 0≦z≦1, 0≦p≦1, 0≦q≦1, and x+y+z=1, p+q=1); the said light emitting layer 24 can be composed by one of B ₓ Al _{y} In _{z} Ga _{1-x-y-z} N ₚAs_{q} (0≦x≦ 1, 0≦y≦1, 0≦z≦1, 0≦p≦1, 0≦q≦1, and x+y+z=1, p+q=1), or presented as B ₓ Al _{y} In _{z} Ga _{1-x-y-z} N ₚ P_{q} (0≦x≦1, 0≦y≦1, 0≦z≦1, 0≦p≦1, 0≦q≦1, and x+y+z=1, p+q=1), or combined by the two aforementioned layer to form quantum well structure.

And the said p-type transition layer 262 and the said p-type ohmic contact 264 are superlattice structure composed by a semiconductor layer. The said superlattice structure can be stacked by the different compositions, thickness, and doped concentration of semiconductor layer.

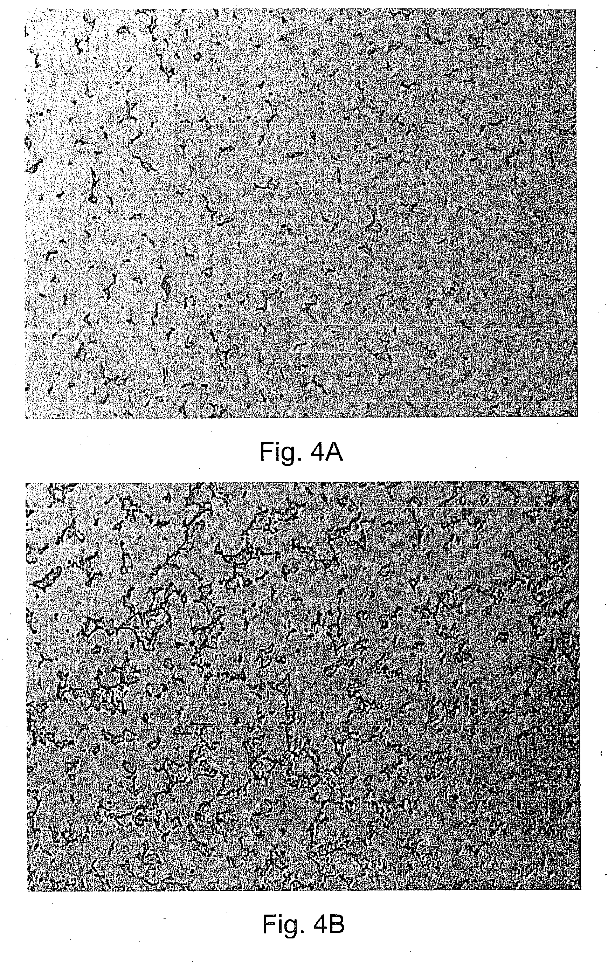

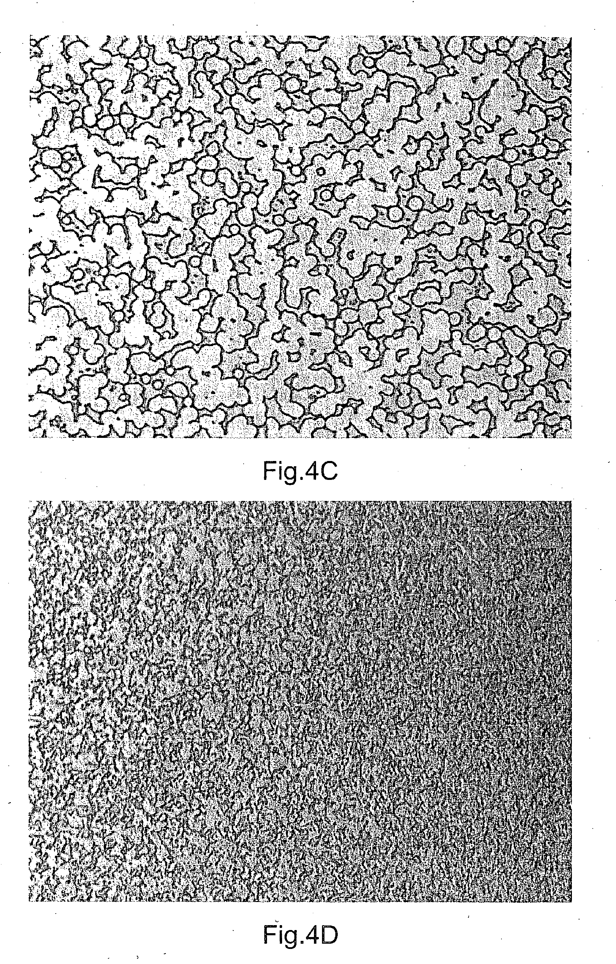

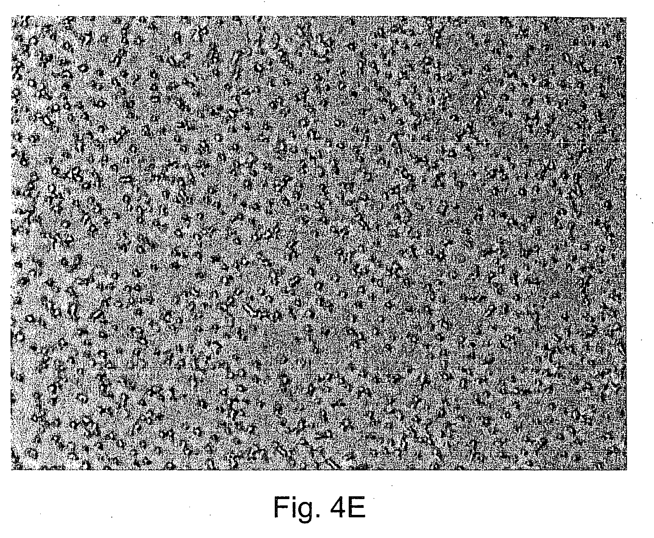

The said p-type semiconductor layer 26 has a textured surface that can interrupt the optical waveguide effect, and the said p-type cladding layer consists of magnesium doping concentration in a range of from 5×10¹⁹ to 5×10²⁰ cm⁻³, the said p-type transition layer consists of magnesium doping concentration in a range of from 5×10¹⁷ to 5×10¹⁹ cm⁻³, the magnesium doping concentration of said p-type ohmic contact layer is between the said p-type cladding layer and p-type transition layer; wherein the textured surface of said p-type semiconductor layer shown as from Fig. 4A to 4E which exhibits the texture of SEM of p-type semiconductor layer of a preferred embodiment of the present invention. It illustrates that the texture generated during the epitaxial process and not from the post machining process as prior arts. Therefore, the said texture can be generated during the epitaxial process to achieve the purpose of interrupting optical waveguide effect.

The present invention is a method of directly controlling the texture generation without post machining during manufacturing. The texture generated on the p-type semiconductor layer is a function of light scattering to interrupt optical waveguide effect composed by the substrate and resin capper materials for packaging and to increase external quantum efficiency and to reduce the possibility of hexagonal shaped pits generation and to increase the operation life of device.

While certain preferred embodiments of the present invention have been disclosed in detail, it is to be understood that various modifications may be adopted without departing from the spirit of the invention or scope of the following claims.

The features disclosed in the foregoing description, in the claims and/or in the accompanying drawings may, both separately and in any combination thereof be material for realising the invention in diverse forms thereof.

## Claims

1. A high light efficiency of GaN-series of light emitting diode comprising:
a substrate;
a semiconductor, which formed on the said substrate that including a n-type semiconductor, a light emitting layer, a p-type semiconductor layer;
wherein said light emitting layer is between said n-type semiconductor layer and said p-type semiconductor layer, and the surface of said p-type semiconductor layer have a texture that generated from a epitaxial process.

2. The light emitting diode in accordance with claim 1, wherein the surface of said p-type semiconductor layer having a texture can interrupt optical waveguide effect.

3. The high light efficiency of GaN-series of light emitting diode in accordance with claim 1, wherein the surface of said p-type semiconductor layer having a texture is formed by controlling the strain during epitaxy of p-type semiconductor layer.

4. The light emitting diode in accordance with claim 1, wherein the said p-type semiconductor layer further comprising a p-type cladding layer and a p-type transition layer formed on said p-type cladding layer and a p-type ohmic contact layer formed on said p-type transition layer.

5. The light emitting diode in accordance with claim 1, wherein further comprising a reflection layer under said light emitting layer.

6. The light emitting diode in accordance with claim 1, wherein said substrate is selected from one of sapphire, silicon carbide, zinc oxide, zirconium diboride, gallium arsenide or silicon.

7. The light emitting diode in accordance with claim 1, wherein said n-type semiconductor layer can be presented as N-B ₓ Al _{y} In _{z} Ga _{1-x-y-z} N ₚ As_{q} (0≦x≦1, 0 ≦y≦1, 0≦z≦1, 0≦p≦1, 0≦q≦1, and x+y+z=1, p+q=1), or presented as N- B ₓ Al _{y} In _{z} Ga _{1-x-y-z} N ₚ P_{q} (0≦x≦1, 0≦y≦1, 0≦z≦1, 0≦p≦1, 0≦q≦1, and x+y+z=1, p+q=1).

8. The light emitting diode in accordance with claim 1, wherein said p-type semiconductor layer can be presented as P- B ₓ Al _{y} In _{z} Ga _{1-x-y-z} N ₚ As_{q} (0≦x≦1, 0≦y≦1, 0≦z≦1, 0≦p≦1, 0≦q≦1, and x+y+z=1, p+q=1), or presented as P- B ₓ Al _{y} In _{z} Ga _{1-x-y-z} N ₚ P_{q} (0≦x≦1, 0≦y≦1, 0≦z≦1, 0≦p≦1, 0≦q≦1, and x+y+z=1, p+q=1).

9. The light emitting diode in accordance with claim 1, wherein said light emitting can be composed by one of B ₓ Al _{y} In z Ga _{1-x-y-z} N ₚ AS_{q} (0≦x≦1, 0≦y≦1, 0≦z≦1, 0≦p≦1, 0≦q≦1, and x+y+z=1, p+q=1), or presented as B ₓ Al _{y} In _{z} Ga _{1-x-y-z} N ₚ P_{q} (0≦x≦1, 0≦y≦1, 0≦z≦1, 0≦p≦1, 0≦q≦1, and x+y+z=1, p+q=1), or combined by the two aforementioned layer to form quantum well structure.

10. The light emitting diode in accordance with claim 4, wherein said p-type cladding layer is a cladding layer which alters tension strain.

11. The light emitting diode in accordance with claim 4, wherein said p-type transition layer is superlattice structure composed by a semiconductor layer.

12. The light emitting diode in accordance with claim 4, wherein said p-type ohmic contact layer is superlattice structure composed by a semiconductor layer.

13. The light emitting diode in accordance with claim 4, wherein said p-type cladding layer comprising a doping concentration of magnesium is in a range of from 5×10¹⁹ to 5×10²⁰ cm⁻³.

14. The light emitting diode in accordance with claim 4, wherein said p-type transition layer comprising a doping concentration of magnesium is in a range of from 5×10¹⁷ to 5×10¹⁹ cm⁻³.

15. The light emitting diode in accordance with claim 4, wherein the said p-type ohmic contact layer comprising a doping concentration of magnesium is between said p-type cladding layer and p-type transition layer.

16. The light emitting diode in accordance with claim 11 and 12, wherein said superlattice structure can be stacked by the different compositions, thickness, and doped concentration of semiconductor layer.

17. The light emitting diode in accordance with claim 5, wherein said reflection layer is formed as a Distributed Bragg Reflector which is stacked by semiconductor layer.

18. A manufacturing of light emitting diode comprising the steps of:
providing a substrate; and
forming a semiconductor layer on said substrate to be a light emitting device, wherein said semiconductor layer at least containing a light emitting layer, a p-type semiconductor layer and a n-type semiconductor, and said light emitting layer is between the said n-type semiconductor layer and the p-type semiconductor layer;
wherein forming of said p-type semiconductor comprises the steps of:
forming a p-type cladding layer on said light emitting layer, wherein said p-type cladding layer has an increase of strain in proportion to each layer;
forming a p-type transition layer on said p-type cladding layer; and
forming a p-type ohmic contact layer on said p-type transition layer.

19. The manufacturing method in accordance with claim 18, wherein said p-type cladding layer is doped with magnesium to increase the strain in proportion to each layer.

20. The manufacturing method in accordance with claim 18, wherein the formation of said p-type cladding layer is doped with magnesium to increase the strain in proportion to each layer and then interrupt epitaxial growth and alter the strain of epitaxy layers by controlling the interruption time.

21. The manufacturing method in accordance with claim 18, wherein the formation of said p-type cladding layer is doped with magnesium to increase the strain in proportion to each layer and then interrupt epitaxial growth and alter the strain of epitaxy layers by utilizing the change of temperature.

22. The manufacturing method in accordance with claim 18, wherein the formation of said p-type cladding layer is doped with magnesium to increase the strain in proportion to each layer and then interrupt epitaxial growth and alter the strain of epitaxy layers by forming several monolayers comprising of gallium, indium, or aluminum on the surface of p-type cladding layer.

23. The manufacturing method in accordance with claim 18, wherein the formation of said p-type cladding layer is increasing aluminum composition of p-type cladding layer to raise the strain of epitaxy layers, then interrupt the epitaxial growth and control the interruption time to alter the strain of epitaxy layers.

24. The manufacturing method in accordance with claim 18, wherein the formation of said p-type cladding layer is increasing aluminum composition of p-type cladding layer to raise the strain of epitaxy layers, then interrupt the epitaxial growth and utilize the change of temperature to alter the strain of epitaxy layers.

25. The manufacturing method in accordance with claim 18, wherein the formation of said p-type cladding layer is increasing aluminum composition of p-type cladding layer to raise the strain of epitaxy layers, then interrupt the epitaxial growth and form several monolayers comprising of gallium, indium or aluminum on the surface of p-type cladding layer to alter the strain of epitaxy layers.

26. The manufacturing method in accordance with claim 18, wherein the formation of said p-type transition layer is to control the composition of aluminum among the epitaxy or a dopant of magnesium to reduce the strain in proportion to p-type cladding layer.

27. The manufacturing method in accordance with claim 18, wherein the formation of said p-type transition layer is to reduce the strain between epitaxy layers and p-type cladding layer, next to interrupt epitaxial growth and to control the interruption time to alter the strain of epitaxy layers.

28. The manufacturing method in accordance with claim 18, wherein the formation of said p-type transition layer is to reduce the strain between epitaxy layers and p-type cladding layer, next to interrupt epitaxial growth and to utilize the change of temperature to alter the strain of epitaxy layers.

29. The manufacturing method in accordance with claim 18, wherein the formation of said p-type transition layer is to reduce the strain between epitaxy layers and p-type cladding layer, next to interrupt epitaxial growth and to form several monolayers comprising of gallium, indium or aluminum on the surface of p-type cladding layer to alter the strain of epitaxy layers, wherein the monolayer is from one to five.

30. The manufacturing method in accordance with 20 or 23 or 27, wherein the interruption time is in a range of from one second to two minutes.

31. The manufacturing method in accordance with 21 or 24 or 28, wherein the change temperature is in a range of from 5°C to 300°C.

32. The manufacturing method in accordance with 22 or 25 or 29, wherein the monolayer in is in a range of from one to five.

33. The manufacturing method in accordance with claim 18, wherein the formation of said p-type ohmic contact layer is utilize epitaxial growth to increase bis(cyclopentadienyl) magnesium (Cp₂Mg) flow or reduce temperature to increase concentration of dopant such as magnesium.
